Europäisches Patentamt

European Patent Office

Office européen des brevets

(19)

(11) Publication number: **0 005 601**
**B1**

(12) **EUROPEAN PATENT SPECIFICATION**

(45) Date of publication of patent specification: **02.03.83**

(51) Int. Cl.³: **H 01 L 27/02, G 11 C 11/40**

(21) Application number: **79300757.6**

(22) Date of filing: **02.05.79**

(54) Semiconductor integrated memory circuit.

(30) Priority: **11.05.78 JP 56007/78**
**02.03.79 JP 24983/79**

(43) Date of publication of application:
**28.11.79 Bulletin 79/24**

(45) Publication of the grant of the patent:
**02.03.83 Bulletin 83/9**

(84) Designated Contracting States:
**DE GB NL**

(56) References cited:
**IEEE JOURNAL OF SOLID-STATE CIRCUITS, vol. 8, October 1973, New York**
**S. K. WIEDMANN "Injection-coupled memory: a high-density static bipolar memory", pages 332—337**

(73) Proprietor: **Nippon Telegraph and Telephone Public Corporation**
**1-6 Uchisaiwai-cho, 1-chome Chiyoda-ku Tokyo 100 (JP)**

(73) Proprietor: **FUJITSU LIMITED**
**1015, Kamikodanaka Nakahara-ku Kawasaki-shi Kanagawa 211 (JP)**

(72) Inventor: **Kawarada, Kuniyasu**
**30-5 Kitamachi 1-chome Kichijyoji Musashino-shi Tokyo 180 (JP)**
Inventor: **Ono, Chikai**
**322 Seki Tama-ku Kawasaki-shi Kanagawa 214 (JP)**
Inventor: **Suzuki, Masao**
**890 minami-cho 1-chome Hanakoganei Kodaira-shi Tokyo 187 (JP)**
Inventor: **Toyoda, Kazuhiro**
**39 Sakuradai Midori-ku Yokohama-shi Kanagawa 227 (JP)**

(74) Representative: **Rackham, Stephen Neil et al, GILL JENNINGS & EVERY 53/64 Chancery Lane London WC2A 1HN (GB)**

# Semiconductor integrated memory circuit.

The present invention relates to a semiconductor integrated circuit memory device wherein memory cells formed by integrated injection logic cells are arranged in an array.

Integrated injection logic memory cells are a great advance because they can be formed with a very high packing density. Such memory cells are disclosed, for example, in articles entitled "Write Current Control and Self Powering in a Low Power Cell" published in IEEE, SSC, Jun., 1073, and "Superintegrated Memory Shares Functions on Diffused Islands" published in Electronics, February 14th, 1972, p. 83—p. 86. The former discloses a method of controlling a write current to the integrated injection logic memory cell and the latter discloses the basic idea of an integrated injection logic memory cell.

An integrated injection logic memory cell comprises a first and second transistor of a first conduction type which have a common emitter forming an injector which is connected to a first word line, a third and fourth transistor which have their collectors connected to the collector of the first or second transistor, respectively, the base of the third transistor is connected to the collector of the fourth transistor and the base of the fourth transistor connected to the collector of the third transistor, the third and fourth transistors being of a second conduction type, and the first and second transistors having their bases connected to the emitters of the third and fourth transistors and to a second word line.

Integrated injection logic memory cells may also include fifth and sixth transistors of the second conduction type which have their bases connected to the bases of the bases of the third and fourth transistors, respectively which have their collectors connected to the second word line, and which have their emitters connected to the first and second bit lines, respectively.

When the integrated injection logic memory cells are arranged in an array, the bases of the first and second transistors, the emitters of the third and fourth transistors and the second word line are formed as a bulk which usually consists of two n type layers, an epitaxial layer and a buried layer. The epitaxial layer is formed on the buried layer which has a higher n-type impurity than the epitaxial layer. Therefore, the bulk has a larger resistance than a metal conductor, and so some resistance is present between each cell connected to the second word line.

When the bulk is used as the second word line it supplies a hold current, and the characteristics of the cells are different in accordance with the positions of the cells along a line of the array. Particularly, a write threshold current and the width of a write pulse required have larger values in cells near the ends of the lines of the array. Thus, it is an object of the present invention to equalise the characteristics of all of the integrated injection logic memory cells in the memory array.

According to this invention, this is achieved by providing at least one dummy cell at each end of each line of the memory cell array, the dummy cells being arranged to shunt a part of the write current flowing when an integrated injection logic memory cell within the corresponding line is selected.

Various examples of semiconductor devices in accordance with this invention will now be described and contrasted with earlier conventional devices with reference to the accompanying drawings; in which:—

Figures 1A, 1B and 1C illustrate equivalent circuits of an integrated injection logic memory cell forming one bit of a memory cell array;

Figure 2 illustrates a cross-section through an integrated injection logic memory cell;

Figures 3A, 3B, 3C and 3D illustrate an equivalent circuit of one line of a conventional integrated injection memory cell array and the characteristics of the memory cells in that line;

Figures 4A, 4B and 4C illustrate an equivalent circuit of one line of an integrated injection memory cell array in accordance with the present invention and the characteristics of the memory cells in that line;

Figures 5A, 5B and 5C illustrate three embodiments of the semiconductor integrated circuit device;

Figures 6A, 6B and 6C illustrate an equivalent circuit of another embodiment of the present invention and the characteristics of this embodiment; and,

Figures 7A and 7B illustrate two further embodiments of the device illustrated in Figure 6A.

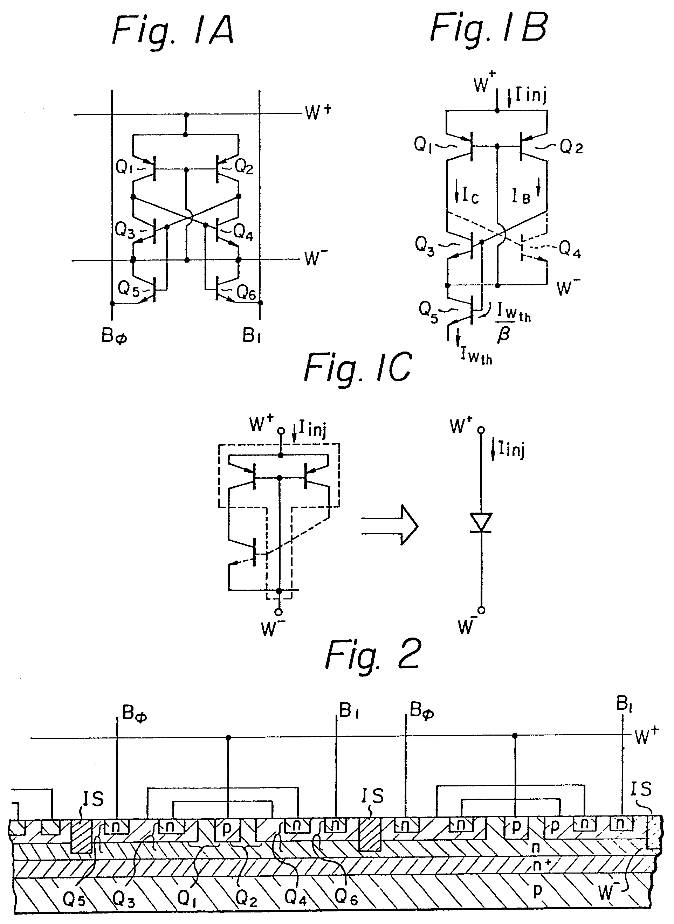

In Figure 1A, $Q_1$ to $Q_6$ designate transistors, W+ and W— designate first and second word lines and $B_1$, B$\emptyset$ designate bit lines.

Referring to Figures 1A and 2, a p-type conduction region which is connected to the word line W+ is the common emitter of the lateral pnp transistors $Q_1$, $Q_2$ and forms the injector. The transistors $Q_1$, $Q_2$ are used as loads, the collector region connected to a word line W— of npn transistors $Q_3$ and $Q_4$ are used as emitters and the usual emitter regions of npn transistors $Q_3$ and $Q_4$ are used as collectors. Therefore, a bulk, that is an n-type conduction region, which is used as the bases of the pnp transistors $Q_1$, $Q_2$ and as the emitters of, the npn transistors $Q_3$, $Q_4$ is used as a buried word line W—, so that the cells are formed with a high packing density.

Referring to the memory cell shown in Fig. 1A, transitors $Q_3$ and $Q_4$ are placed in the on and off state alternately. When the transistor $Q_3$ is placed in the on state, the transistor $Q_4$ is placed in the off state. Fig. 1B illustrates an equivalent circuit of Fig. 1A when the transistor $Q_3$ is placed in the on state. An injection

current Iinj supplies a base current of an on state transistor $Q_3$. In order to change the cell information, the on state transistor $Q_3$ should be changed to off state. This is done by bypassing the base current $I_B$ of the transistor $Q_3$ to the base current of a coupling transistor $Q_5$ the emitter current of which corresponds to write threshold current Iwth.

As the injection current Iinj, the write threshold current Iwth depends on the injection current Iinj. Fig. 1C shows that an equivalent circuit of a memory cell which is not selected is replaced to an equivalent diode.

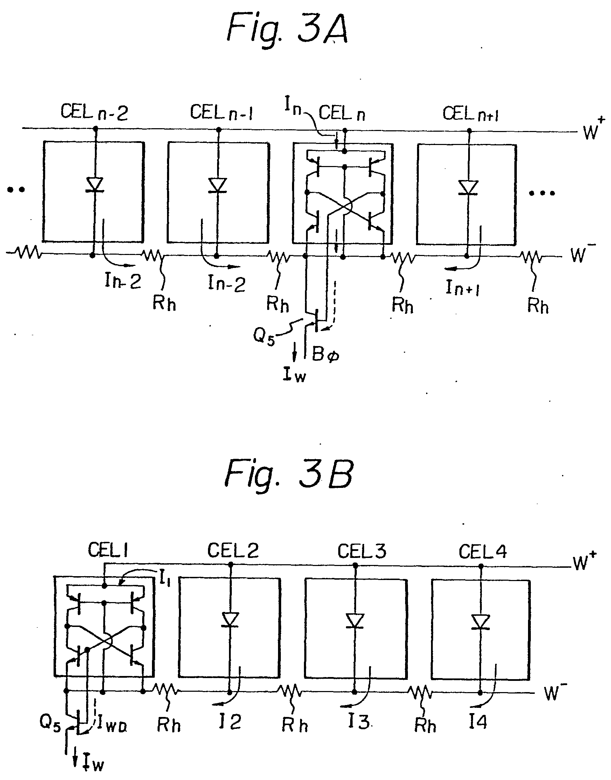

Figs. 3A and 3B illustrate equivalent circuits of one row of a random access memory cell array which is constituted by using the memory cells shown in Figs. 1A and 2. Referring to Figs. 3A and 3B, $CEL_1$, $CEL_2$, . . ., $CEL_{n-1}$, $CEL_n$, $CEL_{n+1}$ designate a first, a second, . . . an n − 1th, an n'th, and an n + 1th cell, respectively. Fig. 3A illustrates the case where the $CEL_n$ in a middle portion of the line is selected, and Fig. 3B illustrates the case where the $CEL_1$ at the end of the line is selected. In Figs. 3A and 3B, the word line W− is formed as the bulk, as already mentioned, and the bulk is usually formed by the n+ buried layer and n epitaxial layer. The bulk, that is, the word line W−, has a larger resistance than the metalic wire and, therefore, a resistances Rh exists between two adjacent cell.

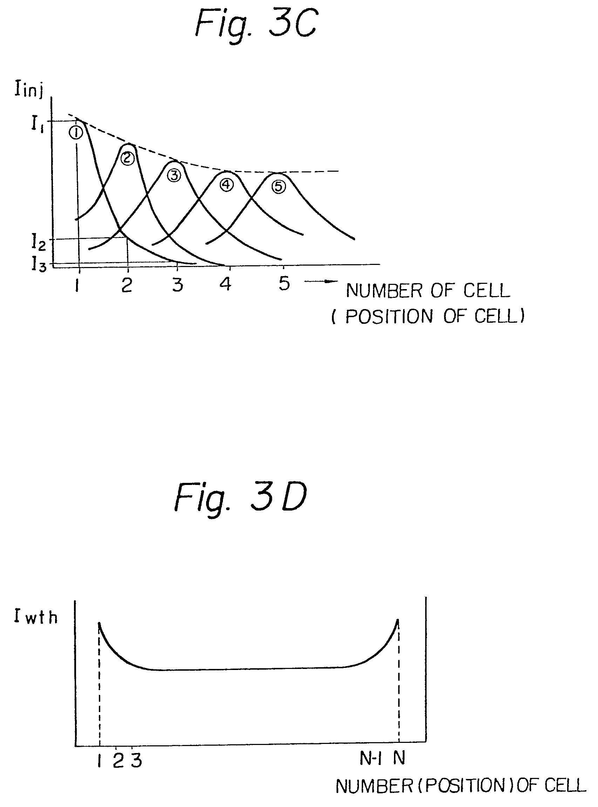

When the bulk is used as the word line W− for supplying a hold current, the characteristics of the cells vary; due to the resistance of the bulk $R_H$ in between two cells, in accordance with the position of the cells in the line. Especially, a large write threshold current which is proportional to the injection current and a wide width of the write pulse are required in the cell near the end of the line. Fig. 3C illustrates a relation between the injection current Iinj and the position of the cell, and Fig. 3D illustrates a relation between the write threshold current Iwth and the position of the cell. Referring to Fig. 3C and 3D, the ordinate designates the injection current and the write threshold current, respectively, and the abscissa designates the cell number or the position of the cell.

When information is written in the selected n'th cell $CEL_n$ indicated in Fig. 3A, the write current Iw is supplied to either one of the bit lines $B_1$, B∅ through the coupling transistor $\theta5$. However, in this case, the write current Iw flows in other non-selected cells, besides the n'th cells $CEL_n$, as an injector current. This phenomenon can be understood from the fact that, each cell $CEL_{n-1}$, $CEL_n$, $CEL_{n+1}$ can be equivalently represented as an injector diode which is connected to the word line W−. The current which flows in the non-selected cells decreases exponentially, due to the resistance of the word line, from the n'th $CEL_n$. Therefore, in this case, the currents In − 1, In + 1 which flow in the n − 1th cell and the n + 1th cell respectively, are most dominant as a shunt current. That is, the current In which flows in the nth cell $CEL_n$ is affected by the currents In − 1, In + 1 which flow in the n − 1th cell and the n + 1th cell respectively. However, when the first cell $CEL_1$ which is positioned at the end of the array is going to be written, the write current Iw is shunted only at one side, such as cell $CEL_2$. That is, when the information is written in the cell positioned at the end of the array, the write current Iw is not shunted at the other side, so that, therefore, the injector current in the cell where the information is written increases. In Fig. 3C, the curves ①, ②, ③, . . . show the distribution the injector currents $I_1$, $I_2$, $I_3$, . . . in Fig. 3B when the write current Iw flows through the $CEL_1$. When we assume that the value of the write current is constant, the injector current which flows in the selected cell positioned at the end of the array when the information is written is larger than the injector current which flows in the selected cell not positioned at the end of the array. Further, as the write threshold current is proportional to the injector current, the write threshold current in the cell positioned at the end of the array is larger than the write threshold current in the cell not positioned at the end of the array. When the write threshold current is large, if we assume that the write current is constant, a charge and discharge current for inverting the state of the cell is not sufficient, so that a write pulse having wide width is required.

As will be understood from the above discussion, when the characteristics of the cell depends on the position of the cell, the design margin is narrow, and therefore, the random access memory characteristics deteriorates.

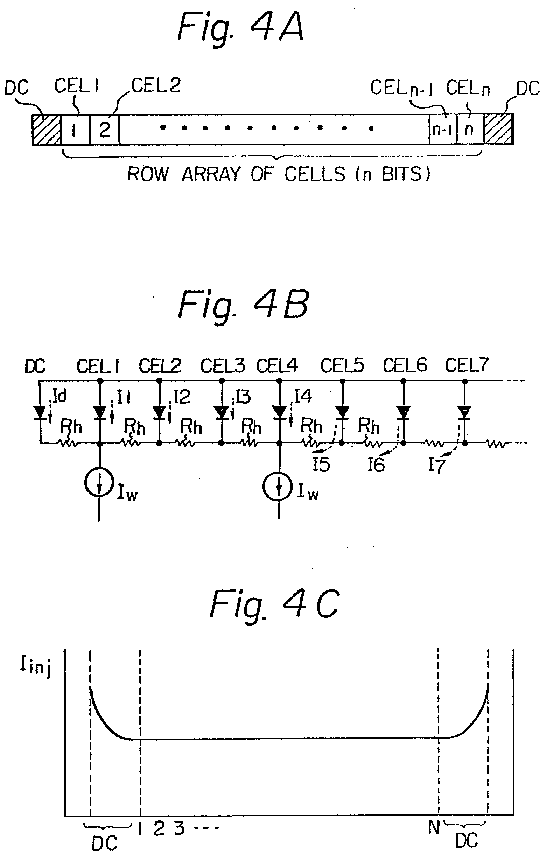

The basic idea of the present invention is very simple. As seen in Figs. 4A and 4B, n cells, $CEL_1$, $CEL_2$, . . ., $CEL_n$, are arranged as an n bits array, and in the present invention, dummy cells DC are arranged at both ends of the array. When information is written in the cell $CEL_1$ or $CEL_n$ positioned at the ends of the array, the write current is shunted by the dummy cell DC, so that an increase of the write threshold current or the width of the write pulse in the cells positioned at the end of the array can be prevented. Fig. 4C represents the relation between the injection current Iinj and the position of the cells which include the dummy cells. In Fig. 4C, the ordinate designates the injection current Iinj, and the abscissa designates the number of the cells and dummy cells positioned at the end of the array.

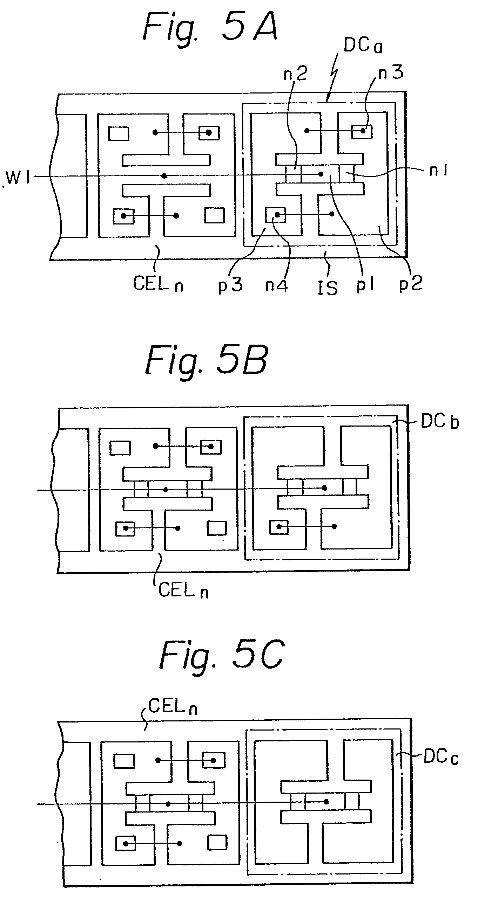

Figs. 5A, 5B and 5C illustrate first embodiments of the semiconductor integrated circuit device according to the present invention. In Figs. 5A, 5B and 5C, the area of the injector in the dummy cell is equal to the area of the injector in the memory cell. In Fig. 5A, IS designates an isolation region, $DC_a$ the dummy cell, $CEL_n$ the memory cell and $W_1$ the word line; $p_1$ designates a p type region which forms the common emitter of the transistor $Q_1$ and $Q_2$ of the memory cell, $n_1$ and $n_2$ an n type regions of the semiconductor layer which form the bases of the transistor $Q_1$ and $Q_2$, $p_2$ a p type region which forms a collector of the transistor $Q_1$ and bases of the transistors $Q_3$ and $Q_5$ and $p_3$ a p type region which forms a collector of the transistor $Q_2$ and bases of the transistors $Q_4$ and $Q_6$; $n_3$ designates an n type region which forms a collector of the transistor $Q_3$, $n_4$ an n type region which forms an emitter of the transistor $Q_4$. Therefore, in Fig. 5A, the dummy cell is formed by the transistors $Q_1$, $Q_2$, $Q_3$ and $Q_4$ which constitute the portion of the memory cell. In Fig. 5B, the dummy cell $DC_b$ is formed by transistors $Q_1$, $Q_2$ and $Q_3$, and in Fig. 5C, the dummy cell $DC_c$ is formed by an injector diode. In the dummy cells illustrated in Figs. 5B and 5C, the same effect can be obtained as in the dummy cell illustrated in Fig. 5A. However, in the embodiments illustrated in Figs. 5A, 5B and 5C, as the shunt current into the dummy cells in inversely proportional to the value of the resistor Rh, the large value of the resistance Rh makes the write threshold current Iwth high. Therefore, in such a case, more than one dummy cells are required to equalize the cell characteristics. If we assume that the memory capacity is constant, the area of the chip of the memory device increases when a number of dummy cells are arranged at the end of the line of the memory array.

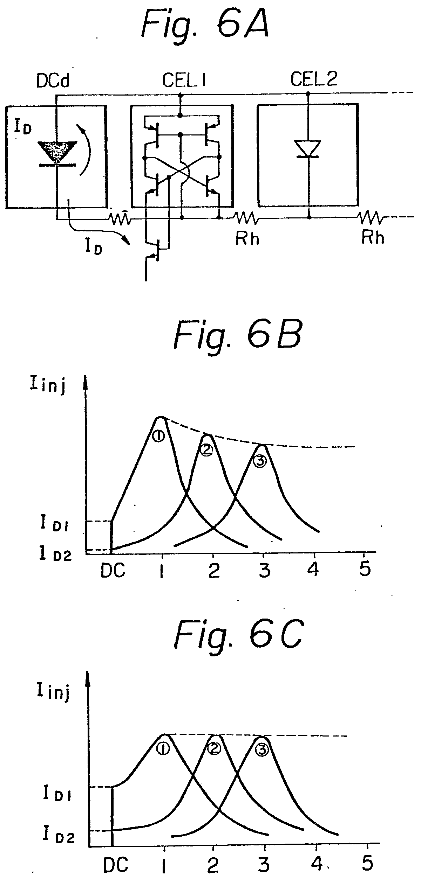

Figs. 6A is an embodiment which can remove the above inconvenience caused in the embodiments illustrated in Figs. 5A, 5B and 5C. In Figs. 6A, $DC_d$ designates a dummy cell, and the injector area of the dummy cell $DC_d$ is selected so that it is larger than that of memory cells $CEL_1$, $CEL_2$. According to experiments conducted by the inventors of the present invention, when the dummy cell has a wide injector area, the value of the injection current of the memory cells can be equalized. Figs. 6B and 6C illustrate the relation between the injection current of the memory cells and the number of memory cells. In Figs. 6B and 6C the ordinate designates the injection current of the memory cells and the abscissa designates the number of memory cells. When the area of the injector region of the dummy cells is small, the value of the injection currents of the memory cells can not be sufficiently equalized, as shown in Fig. 6B. However, when the area of the injector region of the dummy cell is sufficiently large, the currents $I_{D1}$ and $I_{D2}$ which are shunted by the dummy cell increase so that the value of the injection currents of the memory cells can be sufficiently equalized, as shown in Fig. 6C.

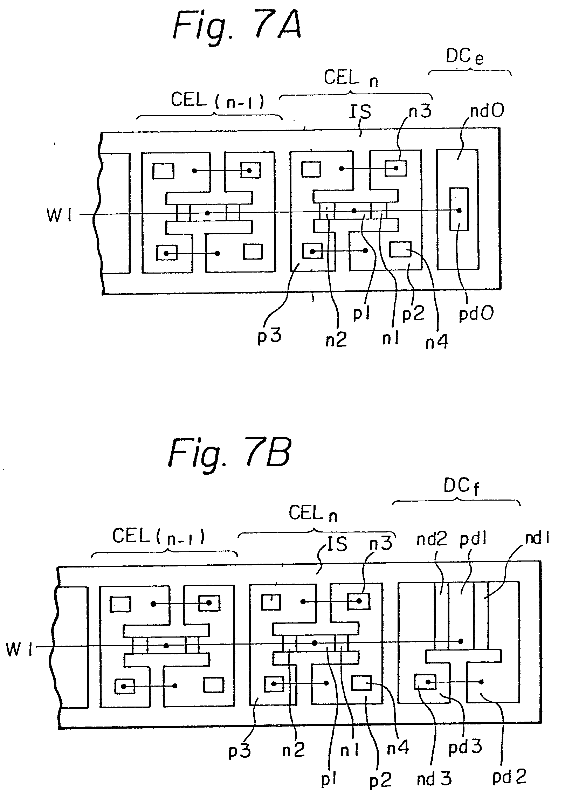

Figs. 7A and 7B illustrate second embodiments of the semiconductor integrated circuit device according to the present invention. In the embodiments illustrated in Figs. 7A and 7B, the area of the injector of the dummy cell is larger than the area of the injector in the memory cell, and the memory cells $CEL_{n-1}$, $CEL_n$ are the same as the memory cells used in the embodiments illustrated in Figs. 5A, 5B and 5C.

In the embodiment shown in Fig. 7A, pdo designates a p type region when the injector of the dummy cell is formed by the diode and ndo designates an n type region, that is, the dummy cell $DC_e$ is formed by the equivalent diode which is illustrated in Fig. 6A, and the area of the injector region is formed so as to equalize the write threshold currents of the memory cells. In the embodiment illustrated in Fig. 7A, by using the diode construction in the dummy cell, the regions corresponding to the collectors of the transistors $Q_1$, $Q_2$ and the transistors $Q_3$ through $Q_4$ can be eliminated. Therefore, the area of the dummy cells can be decreased, even if the area of the injector region is increased, and the deterioration of the integration density is very small.

In the embodiment illustrated in Fig. 7B, $DC_f$ designates a dummy cell. In the dummy cell $DC_f$, $pd_1$ designates a p type region which forms an emitter of the injector of the dummy cell $DC_f$ and which corresponds to the emitters of the transistors $Q_1$, $Q_2$; $nd_1$, $nd_2$ designate n type regions which form the base of the injector and which correspond to the bases of the transistors $Q_1$, $Q_2$; $pd_2$ designates a p type region which corresponds to the collector of the transistor $Q_1$, $pd_3$ designates a p type region which corresponds to the collector of the transistor $Q_2$ and the base of the transistor $Q_3$, and; $nd_3$ designates an n type region which corresponds to the collector of the transistor $Q_3$. In the embodiment of Fig. 7B, the dummy cell $DC_f$ is formed by the transistors $Q_1$, $Q_2$, $Q_3$ in the memory cell and the area of the injector region of the dummy cell is larger than that of the memory cell, so that the area of the dummy cells can be decreased even if the area of the injection region is increased.

As illustrated above, in the semiconductor integrated, circuit device wherein the memory cell formed by injection integrated logic is arranged according to the present invention, the write threshold current in the memory cell at the end of the array is shunted to the dummy cell, so that the write threshold current in each memory cell can be equalized, and the characteristics of the memory cell can be improved.

## Claims

1. A semiconductor integrated circuit device having an array of memory cells each of which is formed by an integrated injection logic memory cell (CEL) comprising a first and second transistor (Q1, Q2) of a first conduction type which have a common emitter forming an injector, a third and fourth transistor (Q3, Q4) of a second conduction type having their collectors connected to the collector of the first and second transistors respectively, the injector being connected to a first word line (W+), the base of the third transitor being connected to the collector of the fourth transistor, the base of the fourth transistor being connected to the collector of the third transistor, and the first and second transistors having their base connected to the emitters of the third and fourth transistors and to a second word line (W—), characterised in that at least one dummy cell (DC) is provided at each end of each line of the memory cell array, the dummy cells being arranged to shunt a part of the write current flowing when an integrated injection logic memory cell (CEL) within the corresponding line is selected.

2. A semiconductor integrated circuit device having an array of memory cells each of which is formed by an integrated injection logic memory cell comprising a first and second transistor (Q1, Q2) of a first conduction type which have a common emitter forming an injector, a third and fourth transistor (Q3, Q4) of a second conduction type having their collectors connected to the collector of the first and second transistors respectively, the injector being connected to a first word line (W+), the base of the third transistor being connected to the collector of the fourth transistor, the base of the fourth transistor being connected to the collector of the third transistor, and the first and second transistors having their bases connected to the emitters of the third and fourth transistors and to a second word line (W—) and a fifth and sixth transistor (Q5, Q6) of the second conduction type which have their bases connected to the bases of the third and fourth transistors respectively, and which have their collectors connected to the second word line, the fifth and sixth transistors having their emitters connected to first and second bit lines (B1, BØ) respectively, characterised in that at least one dummy cell (DC) is provided at each end of each line of the memory cell array, the dummy cells being arranged to shunt a part of the write current flowing when an integrated injection logic memory cell (CEL) within the corresponding line is selected.

3. A semiconductor integrated circuit device according to claim 1 or 2, further characterised in that the dummy cells have an injector of the same area as that of the integrated injection logic cells.

4. A semiconductor integrated circuit device according to claim 1, 2 or 3, further characterised in that the dummy cells have the same pattern as the integrated injection logic memory cells.

5. A semiconductor integrated circuit device according to claim 1, 2 or 3, further characterised in that the dummy cells have the same pattern as that formed by the first transistor, the second transistor and the third transistor of the integrated injection logic memory cells.

6. A semiconductor integrated circuit device according to claim 1 or 2, further characterised in that the dummy cells have an injector having a larger area than that of the integrated injection logic memory cells.

7. A semiconductor integrated circuit device according to claim 3 or claim 6, further characterised in that the dummy cells are formed by a diode which is connected between the first word line and the second word line (Figure 7a).

8. A semiconductor integrated circuit device according to claim 6, further characterised in that the dummy cells each comprise a first region (pd1) of the first conduction type which corresponds to the emitters of the first and second transistors, first and second regions (nd1, nd2) of the second conduction type which corresponds to the bases of the first and second transistors, respectively, a second region (pd2) of the first conduction type which corresponds to the collector of the first transistor, a third region (pd3) of the first conduction type which corresponds to the collector of the second transistor and the base of the third transistor, a third region (nd3) of the second conduction type which corresponds to the collector of the third transistor, the second region (pd2) of the first conductivity type being connected to the third region (nd3) of the second conductivity type (Figure 7B).

**Patentansprüche**

1. Integrierte Halbleiterschaltung mit einer Anordnung von Speicherzellen, welche jeweils von einer Injektions-Logikspeicherzelle (CEL) gebildet ist, mit einem ersten und einem zweiten Transistor (Q1, Q2) von einem ersten Leitfähigkeitstyp, welche einen gemeinsamen, einen Injektor bildenden Emitter haben, mit einem dritten und einem vierten Transistor (Q3, Q4) vom zweiten Leitfähigkeitstyp, deren Kollektoren mit dem Kollektor des ersten bzw. des zweiten Transistors verbunden sind, wobei der Injektor mit einer ersten Wortleitung (W+), die Basis des dritten Transistors mit dem Kollektor des vierten Transistors, die Basis des vierten Transistors mit dem Kollektor des dritten Transistors und die Basen des ersten und des zweiten Transistors mit den Emittern des dritten und vierten Transistors und mit einer zweiten Wortleitung (W—) verbunden sind, dadurch gekennzeichnet, daß wenigstens eine blinde Zelle (DC) an jedem Ende jeder Zeile der Speicherzellenanordnung vorgesehen ist, daß die blinden Zellen so angeordnet sind, daß sie einen Teil des Schreibstromes nebenschließen, der dann fließt, wenn eine integrierte Injektions-Logikspeicherzelle (CEL) innerhalb einer entsprechenden Zeile ausgewählt wird.

2. Integrierte Halbleiterschaltung mit einer Anordnung von Speicherzellen, welche jeweils von einer Injektions-Logikspeicherzelle (CEL) gebildet ist, mit einem ersten und einem zweiten Transistor (Q1, Q2) von einem ersten Leitfähigkeitstyp, welche einen gemeinsamen, einen Injektor bildenden Emitter haben, mit einem dritten und einem vierten Transistor (Q3, Q4) vom zweiten Leitfähigkeitstyp, deren Kollektoren mit dem Kollektor des ersten bzw. des zweiten Transistors verbunden sind, wobei der Injektor mit einer ersten Wortleitung (W+), die Basis des dritten Transistors mit dem Kollektor des vierten Transistors, die Basis des vierten Transistors mit dem Kollektor des dritten Transistors und Basen der ersten und des zweiten Transistors mit den Emittern des dritten und vierten Transistors und mit einer zweiten Wortleitung (W—) verbunden sind, und mit einem fünften und einem sechsten Transistor (Q5, Q6) vom zweiten Leitfähigkeitstyp, deren Basen mit den Basen des dritten bzw. vierten Transistors verbunden sind, deren Kollektoren mit der zweiten Wortleitung verbunden sind, und deren Emitter mit der ersten bzw. mit der zweiten Bitleitung (BØ, B1) verbunden sind dadurch gekennzeichnet, daß wenigstens eine blinde Zelle (DC) an jedem Ende jeder Zeile der Speicherzellenanordnung vorgesehen ist, daß die blinden Zellen so angeordnet sind, daß sie einen Teil des Schreibstromes nebenschließen, der dann fließt, wenn eine integrierte Injektions-Logikspeicherzelle (CEL) innerhalb einer entsprechenden Zeile ausgewählt wird.

3. Integrierte Halbleiterschaltungsanordnung nach Anspruch 1 oder 2, dadurch gekennzeichnet, daß die blinden Zellen (DC) einen Injektor haben, dessen Bereich derselbe wie derjenige der integrierten Injektions-Logikzellen ist.

4. Integrierte Halbleiterschaltungsanordnung nach Anspruch 1, 2 oder 3, dadurch gekennzeichnet, daß die bilden Zellen (DC) dasselbe Muster wie die integrierten Injektions-Logikzellen aufweisen.

5. Integrierte Halbleiterschaltungsanordnung nach Anspruch 1, 2 oder 3, dadurch gekennzeichnet, daß die blinden Zellen dasselbe Muster aufweisen, wie es durch den ersten Transistor, den zweiten Transistor und den dritten Transistor der integrierten Injektions-Logikspeicherzellen gebildet wird.

6. Integrierte Halbleiterschaltungsanordnung nach Anspruch 1 oder 2, dadurch gekennzeichnet, daß die blinden Zellen (DC) einen Injektor haben, dessen Bereich größer als derjenige der integrierten Injektions-Logikspeicherzellen ist.

7. Integrierte Halbleiterschaltungsanordnung nach Anspruch 3 oder 6, dadurch gekennzeichnet, daß die bilden Zellen (DC) von einer Diode (DCd) gebildet werden, welche zwischen der ersten Wortleitung und der zweiten Wortleitung geschaltet ist (Fig. 7a).

8. Integrierte Halbleiterschaltungsanordnung nach Anspruch 6 dadurch gekennzeichnet, daß die blinden Zellen (DC) jeweils einen ersten Bereich (pd1) vom ersten Leitfähigkeitstyp umfassen, welche den Emittern der ersten und der zweiten Transistoren entsprechen, und einen ersten und einen zweiten Bereich (nd1, nd2) vom zweiten Leitfähigkeitstyp, welche den Basen der ersten Transistoren bzw. der zweiten Transistoren entsprechen, und einen zweiten Bereich (pd2) vom ersten Leitfähigkeitstyp, welcher dem Kollektor des ersten Transistors entspricht, und einen dritten Bereich (pd3) vom ersten Leitfähigkeitstyp, welcher dem Kollektor des zweiten Transistors und der Basis des dritten Transistors entspricht, und einen dritten Bereich (nd3) vom zweiten Leitfähigkeitstyp, welcher dem Kollektor des dritten Transistors entspricht, wobei der zweite Bereich (pd2) vom ersten Leitfähigkeitstyp mit dem dritten Bereich (nd3) vom zweiten Leitfähigkeitstype verbunden ist (Fig. 7B).

**Revendications**

1. Dispositif à circuit intégré semi-conducteur possédant un réseau de cellules de mémorisation qui sont chacune formée par une cellule de mémorisation à logique à injection intégrée (CEL) comprenant un premier et un deuxième transistor (Q1, Q2) d'un premier type de conduction que possèdent un émetteur commun formant un injecteur, un troisième et un quatrième transistor (Q3, Q4) d'un deuxième type de conduction dont les collecteurs sont respectivement connectés au collecteur des premier et deuxième transistors, l'injecteur étant connecté à une première ligne de mot (W+), la base du troisième transistor étant connectée au collecteur du quatrième transistor, la base du quatrième transistor étant connectée au collecteur du troisième transistor, et les premier et deuxième transistors étant connectés par leurs bases aux émetteurs des troisième et quatrième transistors et à une deuxième ligne de mot (W—), caractérisé en ce qu'il est prévu au moints une cellule fictive (DC) à chaque extrémité de chaque ligne du réseau de cellules de mémorisation, les cellules fictives étant conçues pour dériver une partie du courant d'écriture qui circule lorsqu'une cellule de mémorisation à logique à injection intégrée (CEL) appartenant à la ligne correspondante est sélectionnée.

2. Dispositif à circuit intégré semi-conducteur possédant un réseau de cellules de mémorisation qui sont chacune formée par une cellule de mémorisation à logique à injection intégrée comprenant un premier et un deuxiéme transistors (Q1, Q2) d'un premier type de conduction qui possèdent un émetteur commun formant un injecteur, un troisième et un quatrième transistors (Q3, Q4) d'un deuxième type de conduction dont les collecteurs sont respectivement connectés au collecteur des premier et deuxième transistors, l'injecteur étant connecté à une première ligne de mot (W+), la base du troisième transistor étant connectée au collecteur du quatrième transistor, la base du quatrième transistor étant connectée au collecteur du troisième transistor, et les premier et deuxième transistors étant connectés par leurs bases aux émetteurs des troisième et quatrième transistors et à une deuxième ligne de mot (W—), et un cinquième et un sixième transistors (Q5, Q6) du deuxième type de conduction qui sont respectivement connectés par leurs bases aux bases des troisième et quatrième transistors et dont les collecteurs sont connectés à la deuxième ligne de mot, les cinquième et sixième transistors étant respectivement connectés par leurs émetteurs à une première et une deuxième ligne de bit (B1. BØ), caractérisé en ce qu'il est prévu au moins une cellule fictive (DC) à chaque extrémité de chaque ligne du réseau de cellules de mémorisation, les cellules fictives étant conçues pour dériver une partie du courant d'écriture qui circule lorsqu'une cellule de mémorisation à logique à injection intégrée (CEL) appartenant à la ligne correspondante est sélectionnée.

3. Dispositif à circuit intégré semi-conducteur selon la revendication 1 ou 2, caractérisé en outre en ce que les cellules fictives ont un injecteur de même air que les cellules à logique à injection intégrée.

4. Dispositif à circuit intégré semi-conducteur selon la revendication 1, 2 ou 3, caractérisé en outre en ce que les cellules fictives ont la même configuration que les cellules de mémorisation à logique à injection intégrée.

5. Dispositif à circuit intégré semi-conducteur selon la revendication 1, 2 ou 3, caractérisé en outre en ce que les cellules fictives ont la même configuration que celles formées par le premier transistor, le deuxième transistor et le troisième transistor des cellules de mémorisation à logique à injection intégrée.

6. Dispositif à circuit intégré semi-conducteur selon la revendication 1 ou 2, caractérisé en outre en ce que les cellules fictives ont un injecteur d'une aire supérieure à celle des cellules de mémorisation à logique à injection intégrée.

7. Dispositif à circuit intégré semi-conducteur selon la revendication 3 ou 6, caractérisé en outre en ce que les cellules fictives sont formées par une diode qui est connectée entre la première ligne de mot et la deuxième ligne de mot (figure 7a).

8. Dispositif à circuit intégré semi-conducteur selon la revendication 6, caractérisé en ce que les cellules fictives comprennent chacune une première région (pd1) du premier type de conduction qui correspond aux émetteurs des premier et deuxième transistors, une première et une deuxième région (nd1, nd2) du deuxième type de conduction qui correspond respectivement aux bases des premier et deuxième transistors, une deuxième région (pd2) du premier type de conduction qui correspond au collecteur du premier transistor, une troisième région (pd3) du premier type de conduction qui correspond au collecteur du deuxième transistor et à la base du troisième transistor, une troisième région (nd3) du deuxième type de conduction qui correspond au collecteur du troisième transistor, la deuxième région (pd2) du premier type de conductivité étant connectée à la troisième région (nd3) du deuxième type de conductivité (figure 7B).

*Fig. 1A*

*Fig. 1B*

*Fig. 1C*

*Fig. 2*

1

# Fig. 3A

# Fig. 3B

# Fig. 3C

$I_{inj}$

$I_1$ ①

② ③ ④ ⑤

$I_2$

$I_3$

1  2  3  4  5 → NUMBER OF CELL
( POSITION OF CELL )

# Fig. 3D

$Iwth$

1 2 3          N-1 N

NUMBER (POSITION) OF CELL

*Fig. 4A*

DC  CEL1   CEL2                                    CEL n-1  CEL n   DC

ROW ARRAY OF CELLS (n BITS)

*Fig. 4B*

DC    CEL1    CEL2    CEL3    CEL4    CEL5    CEL6    CEL7

*Fig. 4C*

# Fig. 5A

# Fig. 5B

# Fig. 5C

# Fig. 6A

# Fig. 6B

# Fig. 6C

# Fig. 7A

DC e

CEL n

CEL (n-1)

IS   n3   ndO

W l

p3   n2   pl   p2   n4   pdO
     n1

# Fig. 7B

DC f

CEL n

CEL (n-1)

IS   n3   nd2  pdl   ndl

W l

p3   n2   nl   n4   pd3
     pl    n1   nd3  pd2